# EUROPÄISCHE PATENTANMELDUNG

(11) **EP 1 722 479 A2**
(43) Veröffentlichungstag der Anmeldung: **15.11.2006**
(21) Anmeldenummer: 06009892.8
(22) Anmeldetag: 12.05.2006
(51) Int. Cl.: H04B 1/034

(54) **Handsender**

(30) Priorität: 14.05.2005 DE 202005007668 U
(71) Anmelder: Sommer Antriebs- und Funktechnik GmbH, 73230 Kirchheim/Teck (DE)
(72) Erfinder: Sommer, Frank, 73230 Kirchheim/Teck (DE); Billi, Thomas, 73033 Göppingen (DE)
(74) Vertreter: Ruckh, Rainer Gerhard

(57) **Zusammenfassung**

Die Erfindung betrifft einen Handsender mit einen in einem Gehäuse integrierten, mittels Tasten betätigbaren, Funksignale emittierenden Sender als Bestandteil eines Sender-/Empfängersystems. Der Handsender besteht aus einem Gehäuseoberteil (2), einem Gehäuseunterteil (3), sowie einem im Innenraum des Gehäuses angeordneten, aus flexiblem Material bestehenden Einlegeteil (7) mit Dichtungen bildenden ersten Segmenten und Tastenfelder (11) bildenden zweiten Segmenten. Weiter weist der Handsender eine Platine (8) zur Aufnahme von Elektronikkomponenten auf.

## Beschreibung

Die Erfindung betrifft ein Gehäuse für einen Handsender. Derartige Handsender sind Bestandteile von Sender-/Empfängersystemen zur Fernbedienung von Toren, Türen und dergleichen. Die Handsender sind als tragbare Einheiten in einem Gehäuse untergebracht und können mittels Tasten betätigt werden. Zur Betätigung eines Tores oder einer Tür emittiert ein derartiger Handsender Funksignale, die von einem Empfänger an der Tür oder dem Tor als Bestandteil des Sender-/Empfängersystems empfangen werden.

Ein derartiger Handsender ist aus der DE 100 15 104 A1 bekannt. Dieser Handsender ist in einem längsgestreckten zweiteiligen Gehäuse integriert, in welchem eine Batterie, ein Senderbauteil und ein dem Sender steuernder Tastensatz untergebracht sind.

Das Gehäuse ist aus einem einseitig geschlossenen, rohrförmigen Außenteil und einem in diesem längsverschiebbaren, einseitig geschlossenen, rohrförmigen Innenteil gebildet, das die Batterie, das Senderbauteil und den Tastensatz trägt.

Das Außenteil und das Innenteil sind mit Rastmitteln versehen, die derart angeordnet sind, dass die Tasten aus einer durch das Außenteil verdeckten Raststellung in eine durch das Außenteil nicht verdeckten Raststellung gebracht werden können.

Ein Vorteil dieses teleskopartig ausgebildeten Handsenders besteht darin, dass im zusammen geschobenen Zustand der Tastensatz im Innern des Außenteils liegt und so gegen Beschädigungen oder Verschmutzungen geschützt ist.

Ausgehend von diesem Stand der Technik liegt der Erfindung die Aufgabe zugrunde einen hochwertigen Handsender bereitzustellen, welcher rationell und kostengünstig herstellbar ist.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Der erfindungsgemäße Handsender weist einen in einem Gehäuse integrierten, mittels Tasten betätigbaren, Funksignale emittierenden Sender als Bestandteil eines Sender-/Empfängersystems auf. Der Handsender umfasst ein Gehäuseoberteil, ein Gehäuseunterteil, sowie ein im Innenraum des Gehäuses angeordnetes, aus flexiblem Material bestehenden Einlegeteil mit Dichtungen bildenden ersten Segmenten und Tastenfelder bildenden zweiten Segmenten. Weiterhin ist eine Platine zur Aufnahme von Elektronikkomponenten vorgesehen.

Der erfindungsgemäße Handsender weist einen modularen Aufbau mit einer geringen Anzahl von Einzelteilen auf und kann somit einfach und kostengünstig hergestellt werden.

Dieser Vorteil wird dadurch verstärkt, dass einzelne Komponenten des erfindungsgemäßen Handsenders, insbesondere das Einlegeteil, Mehrfachfunktionen übernehmen. Dies trägt wesentlich zur Reduzierung der Teilezahl des Handsenders bei und damit zu einer rationellen Fertigung dieses Handsenders.

Wesentliche Komponenten des Handsenders, insbesondere die Komponenten des Gehäuses sowie das Einlegeteil, bestehen aus Kunststoff-Spritzteilen, welche kostengünstig herstellbar sind.

Ein weiterer wesentlicher Vorteil des erfindungsgemäßen Handsenders besteht darin, dass dessen Komponenten, insbesondere dessen Gehäusekomponenten, Bestandteil eines Bausatzes bilden. Durch Variation einzelner Komponenten des Bausatzes lassen sich dabei mit geringem Aufwand unterschiedliche Varianten des Handsenders realisieren.

Ein wesentlicher Aspekt dieses modularen Konzepts ist weiterhin die Anbindung der Halterung an das Gehäuse des Handsenders. Die Befestigungsmittel zur Kopplung der Halterung an das Gehäuse sind so ausgebildet, dass der Handsender als tragbare Einheit ohne Halterung verwendbar ist. Weiterhin ist vorteilhaft die Kontur der Halterung an die Kontur des Gehäuses des Handsenders angepasst, so dass der an der Halterung befestigte Handsender weder im optischen Gesamteindruck beeinträchtigt ist noch dessen Funktionalität eingeschränkt ist. Dabei ist insbesondere vorteilhaft, dass Anschlussmittel zur Ankopplung des Gehäuses an die Halterung nicht sichtbar sind.

Zur Herstellung des Handsenders sind dessen Komponenten, insbesondere das Gehäuseoberteil, das Gehäuseunterteil, das Einlegeteil sowie die Platine ineinander steckbar. Dies führt zu äußerst kurzen Montagezeiten bei der Fertigung des Handsenders. Weiterhin ist vorteilhaft, dass durch die Anpassung der Formen und Konturen der einzelnen Komponenten separate Mittel zur Lagefixierung dieser Komponenten weitgehend entfallen können.

Eine weitere Rationalisierung des Fertigungsprozesses wird dadurch erzielt, dass sämtliche Elektronikkomponenten auf der Platine integriert sind und somit eine separate, fertig montierbare Einheit unabhängig von den mechanischen Komponenten des Handsenders bilden.

Die Erfindung wird im Nachstehenden anhand der Zeichnungen erläutert. Es zeigen:
- Figur 1:: Einzeldarstellungen der Komponenten eines Ausführungsbeispiels des erfindungsgemäßen Handsenders.
- Figur 2:: Draufsicht auf ein Einlegteil für den Handsender gemäß Figur 1.
- Figur 3:: Handsender gemäß Figur 1 im montierten Zustand ohne Halterung
a) in einer Draufsicht
b) in einer Seitenansicht
c) in einer Querschnittdarstellung.
- Figur 4:: Handsender gemäß Figur 1 im montierten Zustand mit Halterung
a) in einer Draufsicht
b) in einer Seitenansicht
c) in einer Querschnittsdarstellung.

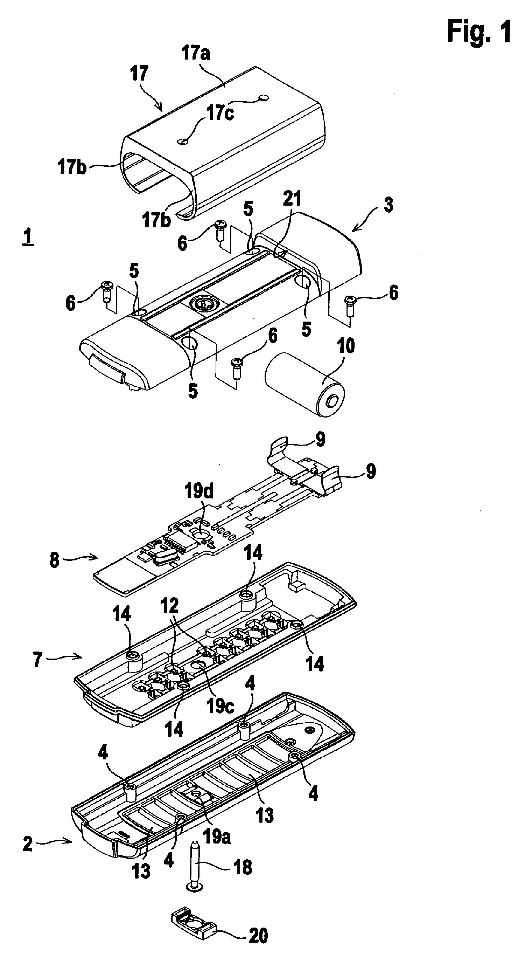

Figur 1 zeigt in einer Einzeldarstellung Komponenten eines Handsenders 1, welcher Bestandteil eines Sender-/Empfängersystems ist und zur Fernbedienung eines Tores, insbesondere eines Garagentores, einer Tür, eine Jalousie, einer Markise, eines Rollladens oder dergleichen dient.

Der Handsender 1 emittiert Funksignale, die zur Fernbedienung der jeweils zu steuernden Einheit von einem Empfänger empfangen werden. Bei Erkennen vorgegebener Codes in den Funksignalen des Handsenders 1 wird mittels des Empfängers die jeweilige Einheit betätigt. Im Fall eines Tores wird dieses beispielsweise vollständig geöffnet oder geschlossen.

Während der Empfänger als stationäres System der zu steuernden Einheit zugeordnet ist, bildet der Handsender 1 eine tragbare mobile Einheit.

Der Handsender 1 gemäß Figur 1 weist ein Gehäuse mit einem Gehäuseoberteil 2 und einem Gehäuseunterteil 3 auf. Diese Komponenten des Gehäuses sind jeweils schalenförmig ausgebildet und bestehen jeweils aus einem Kunststoff-Spritzteil. Als Kunststoffe eignen sich hierfür Polycarbonat, Polyamid oder Polypropylen.

Das Gehäuseoberteil 2 und das Gehäuseunterteil 3 werden zur Gehäusemontage aufeinander gesetzt und durch Schraubverbindungen fixiert. Hierzu sind in dem Gehäuseoberteil 2 Aufnahmen 4 vorgesehen, in welche durch Bohrungen 5 im Gehäuseunterteil 3 geführte Schrauben 6 einführbar sind.

Als weitere Komponenten des Handsenders 1 sind ein aus flexiblem Material bestehendes Einlegteil 7 sowie eine Platine 8, auf welcher sämtliche elektronische Komponenten des Handsenders 1 integriert sind, vorgesehen.

Auf der Platine 8 ist insbesondere eine zwischen Klemmen 9 fixierbare Batterie 10 vorgesehen. Alternativ hierzu können autarke Energieversorgungen in Form eines Akkumulators oder in Form von Solarzellen vorgesehen sein.

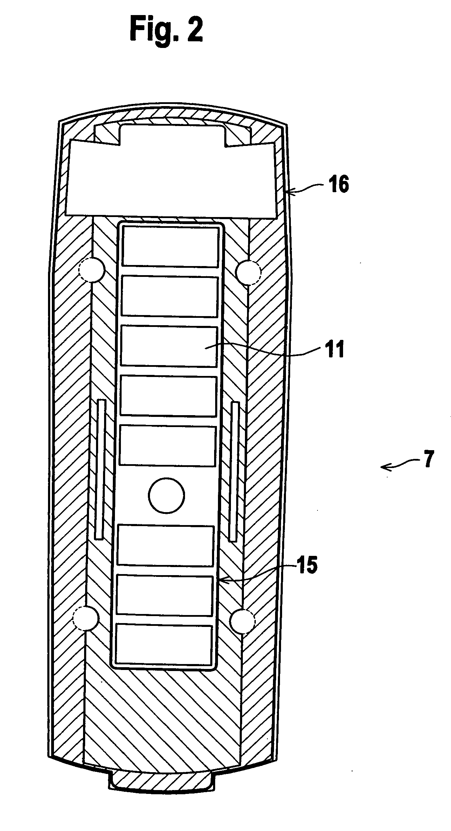

Das Einlegeteil 7 ist in Form eines Kunststoff-Spritzteils ausgebildet, wobei zur Herstellung des Einlegeteils 7 ein flexibler, elastischer Kunststoff wie zum Beispiel TPE verwendet wird. Figur 1 zeigt eine Draufsicht auf die Unterseite des Einlegeteils 7, Figur 2 zeigt eine Draufsicht auf die Oberseite des Einlegeteils 7.

Zur Betätigung des Handsenders 1 sind Tasten vorgesehen, wobei mit diesen unterschiedliche Funktionen des Handsenders 1 aktivierbar sind. Segmente des Einlegteils 7 bilden dabei Tastenfelder 11 dieser Tasten, die von einem Benutzer betätigt werden können. Im vorliegenden Fall weist das Einlegeteil 7 acht derartige Tastenfelder 11 auf, die an der Oberseite des Einlegeteils 7 hervorstehen. Die Tastenfelder 11 weisen im vorliegenden Fall identisch ausgebildete rechteckige Konturen auf.

Die Tastenfelder 11 sind als Auswölbungen im Einlegeteil 7 ausgebildet. Wie aus Figur 1 ersichtlich sind in den Hohlräumen dieser Auswölbungen Pins 12 vorgesehen, welche bei Aufdrücken auf die Tastenfelder 11 gegen nicht dargestellte Kontaktflächen auf der Platine 8 gedrückt werden. Durch die dadurch ausgelösten Kontakte werden die entsprechenden Funktionen des Handsenders 1 aktiviert.

Wie aus Figur 1 ersichtlich weist das Gehäuseoberteil 2 eine Anordnung von Ausnehmungen 13 auf, deren Anzahl und Größen an die Tastenfelder 11 des Einlegeteils 7 angepasst sind. Bei der Montage des Handsenders 1 wird zunächst das Einlegeteil 7 in das Gehäuseoberteil 2 eingelegt, so dass die Tastenfelder 11 durch die Ausnehmungen 13 ragen. Danach wird die Platine 8 in das Einlegeteil 7 eingelegt, wodurch der Kontakt der Pins 12 mit den Kontaktflächen hergestellt wird.

Die Tastenfelder 11 liegen in den Ausnehmungen 13 des Gehäuseoberteils 2 und sind so für einen Benutzer betätigbar. Damit die Tastenfelder 11 auch im Dunkeln für den Benutzer erkennbar sind, können dem Kunststoff, aus welchem das Einlegeteil 7 besteht, fluoreszierende Farbpigmente beigemischt werden, welche Umgebungslicht aufnehmen und dieses im Dunkeln wieder abgeben.

Wie aus den Figuren 1 und 2 erkennbar ist die Kontur des Einlegeteils 7 an die Kontur der Innenseite des Gehäuseoberteils 2 angepasst, so dass bei Einlegen des Einlegeteils 7 in das Gehäuseoberteil 2 dieses dicht und formschlüssig an der Innenwand des Gehäuseoberteils 2 anliegt. Insbesondere sind im Einlegeteil 7 hohlzylindrische Ausformungen 14 vorgesehen, welche die Aufnahmen 4 in dem Gehäuseoberteil 2 umschließen.

An der Oberseite des Einlegteils 7 ist, wie aus Figur 2 ersichtlich, eine erste Dichtungsleiste 15 vorgesehen, welche die Tastenfelder 11 umschließt und in Form eines Wulstes von der Oberseite des Einlegeteils 7 hervorsteht. Bei Einsetzen des Einlegeteils 7 in das Gehäuseoberteil 2 wird die erste Dichtungsleiste 15 gegen die Innenwand des Gehäuseoberteils 2 gedrückt und dichtet so den Bereich der Tastenfelder 11 gegen das Eindringen von Feuchtigkeit und Verschmutzungen ab. Da diese erste Dichtungsleiste 15 Bestandteil des Einlegeteils 7 ist, müssen keine separaten Dichtungsmittel zur Abdichtung der Nahtstellen zwischen den Tastenfeldern 11 des Einlegteils 7 und den Ausnehmungen 13 im Gehäuseoberteil 2 vorgesehen werden.

An dem äußeren Rand des Einlegeteils 7 läuft eine zweite Dichtungsleiste 16 um, welche ebenfalls Bestandteil des Einlegeteils 7 ist. Diese zweite Dichtungsleiste 16 liegt bei in das Gehäuseoberteil 2 eingeführtem Einlegeteil 7 auf dem Rand des Gehäuseoberteils 2 auf. Die zweite Dichtungsleiste 16 bildet damit eine Dichtung zwischen Gehäuseoberteil 2 und Gehäuseunterteil 3. Separate Dichtungen sind zur Abdichtung der Nahtstelle zwischen Gehäuseoberteil 2 und Gehäuseunterteil 3 damit nicht erforderlich. Die zweite Dichtungsleiste 16 kann ohne zusätzliche Montagesschritte durch Einlegen des Einlegeteils 7 in das Gehäuseoberteil 2 installiert werden. Bei Aufsetzen des Gehäuseunterteils 3 auf das Gehäuseoberteil 2 wird dann die zweite Dichtungsleiste 16 zwischen Gehäuseoberteil 2 und Gehäuseunterteil 3 zusammengepresst und dichtet so die Nahtstellen vollständig ab.

Die Kontur der Innenwand des Einlegeteils 7 und die Kontur der Platine 8 mit den Klemmen 9 sind so angepasst, dass bei Einsetzen der Platine 8 in das Einlegeteil 7 die Platine 8 dicht und formschlüssig an Segmenten der Innenwand des Einlegeteils 7 anliegt. Damit ist die Platine 8 durch bloßes Einlegen in das Einlegeteil 7, das heißt ohne den Einsatz zusätzlicher Befestigungsmittel, im Gehäuseoberteil 2 liegend lagefixiert.

Die Platine 8 und das Einlegeteil 7 können so durch einfaches Einsetzen in das Gehäuseoberteil 2 montiert werden. Anschließend muss nur noch das Gehäuseunterteil 3 auf das Gehäuseoberteil 2 aufgesetzt werden und mit den Schrauben 6 fixiert werden.

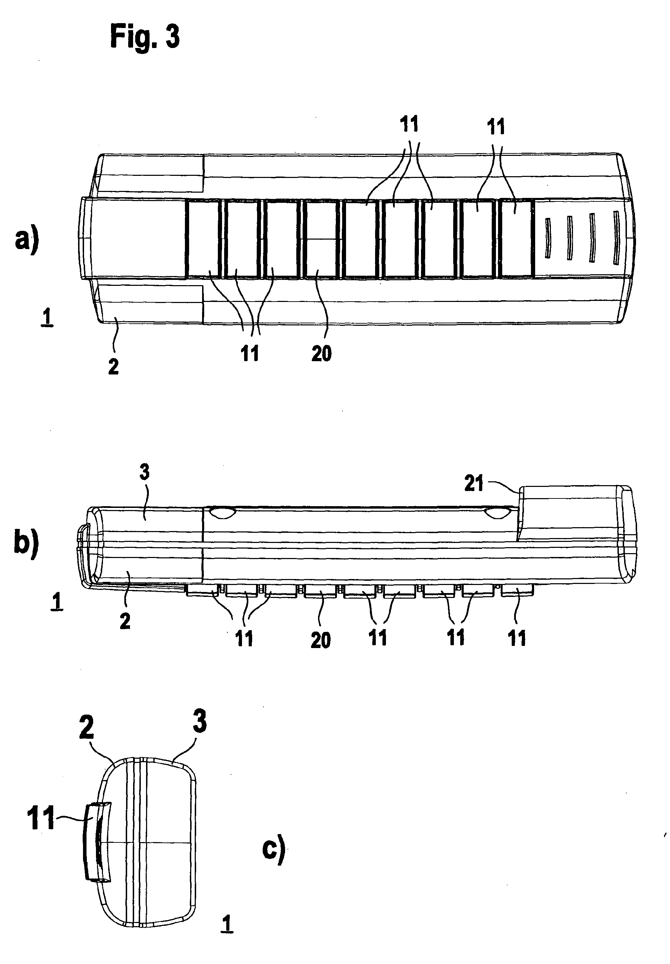

Damit ist der komplette Handsender 1 montiert und funktionsbereit. Die Figuren 3a, b, c zeigen den so montierten Handsender 1. Der Handsender 1 kann durch Drücken der am Gehäuseoberteil 2 freiliegenden Tastenfelder 11 betätigt werden. In der in den Figuren 3a, b, c dargestellten Ausführungsform bildet der Handsender 1 ein tragbares, mobiles Handgerät.

Der Handsender 1 kann auch als stationäre Einheit betrieben werden. Hierzu ist eine Halterung 17 vorgesehen, mit welcher der Handsender 1 an einer Auflage, insbesondere einer Wand montiert werden kann.

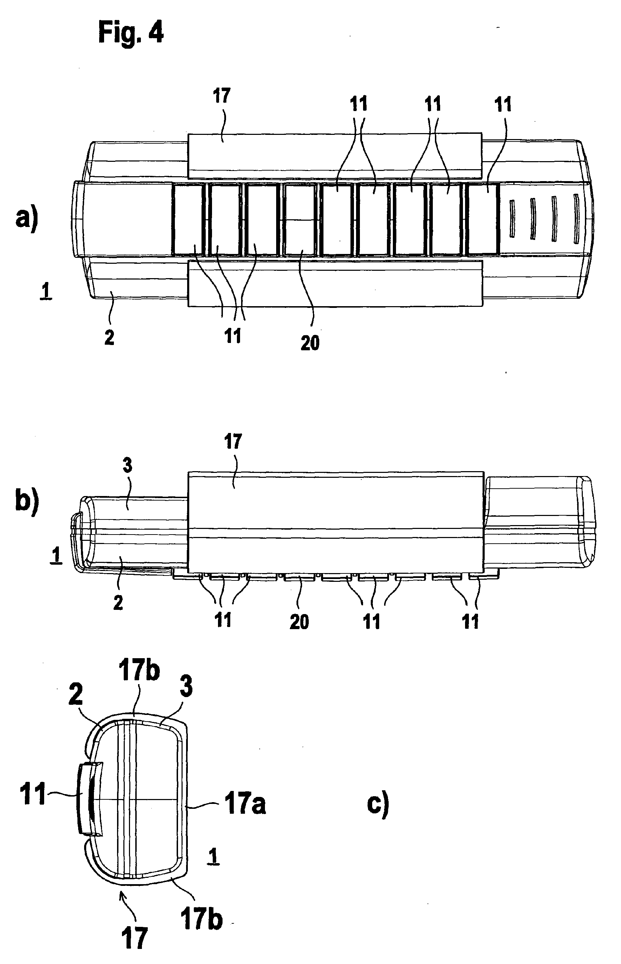

Die Halterung 17 als separates Bauteil ist in Figur 1 dargestellt. Der fertig montierte Handsender 1 mit am Gehäuse montierter Halterung 17 ist in den Figuren 4a, b, c dargestellt.

Die Halterung 17 besteht bevorzugt aus Metall, insbesondere Edelstahl oder wie im vorliegenden Fall aus Aluminium.

Die Halterung 17 ist im Wesentlichen schalenförmig ausgebildet, wobei deren Innenseite an die Kontur des Gehäuses des Handsenders 1 angepasst ist. Die Länge der Halterung 17 ist kleiner als die Länge des Gehäuses, so dass das vordere und hintere Ende des Gehäuses über die Halterung 17 hervorstehen, wie insbesondere aus den Figuren 4a, b ersichtlich ist.

Die Halterung 17 wird am Gehäuse mittels einer Befestigungsschraube 18 befestigt. Die Befestigungsschraube 18 ist dabei in eine Befestigungsbohrung eingeführt, welche das Gehäuse mit den darin angeordneten Komponenten durchsetzt.

In Figur 1 sind in den einzelnen Komponenten, nämlich dem Gehäuseoberteil 2, dem Gehäuseunterteil 3, dem Einlegeteil 7 und der Platine 8, Bohrungen 19 a-d erkennbar, die sich bei montiertem Handsender 1 zur Befestigungsbohrung ergänzen.

Bei dem Handsender 1 mit am Gehäuse fixierter Halterung 17, wie in den Figuren 4a-c dargestellt, durchsetzt die Befestigungsschraube 18 die Befestigungsbohrung und ist mit ihrem vorderen Ende in der Halterung 17 fixiert. Der Kopf der Befestigungsschraube 18 liegt dann im Bereich des Gehäuseoberteils 2. Damit der Kopf der Befestigungsschraube 18 nicht am Gehäuse sichtbar ist, ist dieser mit einer am Gehäuseoberteil 2 einrastbaren Blindkappe 20 abdeckbar.

Die Halterung 17 weist eine Rückwand 17a auf sowie zwei an die Rückwand 17a anschließende Seitenwände 17b, die symmetrisch zur Symmetrieachse der Halterung 17 ausgebildet sind. Die Rückwand 17a weist eine ebene Rückseite auf mit welcher diese an einer Wand oder dergleichen befestigt werden kann. Zur Fixierung der Halterung 17 können Klebemittel oder Schraubverbindungen eingesetzt werden. Im vorliegenden Fall sind hierzu in der Halterung 17 Befestigungsbohrungen 17c vorgesehen.

Bei an dem Gehäuse montierter Halterung 17 liegt die Rückwand 17a am Gehäuseunterteil 3 an. Die bogenförmig ausgebildeten Seitenwände 17b der Halterung 17 liegen seitlich am Gehäuse an. Die vorderen Enden der Seitenwände 17b umgreifen das Gehäuse derart, dass diese an Segmenten des Gehäuseoberteils 2 an der Frontseite des Gehäuses anliegen. Dabei liegen die Ränder der Seitenwände 17b in Abstand zueinander, so dass dazwischen die Tastenfelder 11 des Handsenders 1 zur Bedienung freiliegen.

Durch die Konturanpassung der Innenseite der Halterung 17 an die Außenkontur des Gehäuses liegt die Halterung 17 dicht an diesem an. Auch die Außenkontur der Halterung 17 ist an die Gehäuseform angepasst, so dass die am Gehäuse montierte Halterung 17 die Funktionen des Handsenders 1 nicht beeinträchtigt werden. Zudem wird dadurch eine Anpassung des Designs der Halterung 17 an das Gehäuse erzielt.

Das Gehäuse wird zur Montage an der Halterung 17 in den Zwischenraum zwischen den Seitenwänden 17b der Halterung 17 eingesteckt. Dabei ist als Anschlag für die Einführbewegung ein Absatz 21 am Gehäuseunterteil 3 vorgesehen.

Sobald die Halterung 17 bis zum Absatz 21 auf das Gehäuse aufgeschoben ist, liegt diese in der Sollposition, in welcher mittels der Befestigungsschraube 18 die Halterung 17 am Gehäuse fixierbar ist.

Der Handsender 1 gemäß den Figuren 1 bis 4 weist einen modularen Aufbau auf, wobei die einzelnen Komponenten des Handsenders 1 Bestandteile eines Bausatzes bilden. Damit können auf einfache Weise unterschiedliche Varianten des Handsenders 1 generiert werden.

Hierzu kann insbesondere das Gehäuseoberteil 2 und gegebenenfalls auch das Einlegeteil 7 in geeigneter Weise variiert werden. Das Gehäuseoberteil 2 kann beispielsweise hinsichtlich Material, Form und Farbgebung variiert werden. Auch die Anzahl und Anordnung der Tastenfelder 11 kann entsprechend variiert werden.

Weiterhin kann im Gehäuseoberteil 2 auch ein Sichtfenster integriert werden, durch welches unterschiedliche Anzeigeelemente, beispielsweise Zeit- oder Temperaturanzeigen, sichtbar sind. Das Sichtfenster kann als separate Einlegescheibe im Gehäuseoberteil 2 ausgebildet sein. Besonders vorteilhaft ist das Sichtfenster Bestandteil des Kunststoffspritzteils zur Ausbildung des Gehäuseoberteils 2, wobei hierzu transparente Kunststoffe verwendet werden.

Weiterhin können auch Varianten des Handsenders 1 vorgesehen sein, bei welchen als weitere Bedienelemente Einstellräder am Gehäuse betätigbar angeordnet sind.

Bezugszeichenliste
- (1): Handsender
- (2): Gehäuseoberteil
- (3): Gehäuseunterteil
- (4): Aufnahme
- (5): Bohrung
- (6): Schraube
- (7): Einlegeteil
- (8): Platine
- (9): Klemme
- (10): Batterie
- (11): Tastenfeld
- (12): Pin
- (13): Ausnehmung
- (14): Ausformung
- (15): Dichtungsleiste
- (16): Dichtungsleiste
- (17): Halterung
- (17a): Rückwand
- (17b): Seitenwand
- (17c): Befestigungsbohrung
- (18): Befestigungsschraube
- (19a-d): Bohrung
- (20): Blindkappe
- (21): Absatz

## Patentansprüche

1. Handsender mit einen in einem Gehäuse integrierten, mittels Tasten betätigbaren, Funksignale emittierenden Sender als Bestandteil eines Sender-/Empfängersystems, mit einem Gehäuseoberteil (2), einem Gehäuseunterteil (3), sowie einem im Innenraum des Gehäuses angeordneten, aus flexiblem Material bestehenden Einlegeteil (7) mit Dichtungen bildenden ersten Segmenten und Tastenfelder (11) bildenden zweiten Segmenten, und mit einer Platine (8) zur Aufnahme von Elektronikkomponenten.

2. Handsender nach Anspruch 1, **dadurch gekennzeichnet, dass** dieser eine an Segmenten der Außenwände des Gehäuseoberteils (2) und/oder Gehäuseunterteils (3) anliegende Halterung (17) aufweist.

3. Handsender nach einem der Ansprüche 1 oder 2, **dadurch gekennzeichnet, dass** dessen Komponenten Bestandteile eines Bausatzes sind.

4. Handsender nach einem der Ansprüche 1 bis 3, **dadurch gekennzeichnet, dass** das Gehäuseunterteil (3), das Gehäuseoberteil (2) und das Einlegeteil (7) jeweils aus einem Kunststoff-Spritzteil bestehen.

5. Handsender nach Anspruch 4, **dadurch gekennzeichnet, dass** das Gehäuseunterteil (3) und das Gehäuseoberteil (2) jeweils aus Polycarbonat, Polyamid oder aus Polypropylen bestehen.

6. Handsender nach einem der Ansprüche 4 oder 5, **dadurch gekennzeichnet, dass** das Einlegeteil (7) aus TPE besteht.

7. Handsender nach Anspruch 6, **dadurch gekennzeichnet, dass** das Einlegeteil (7) fluoreszierende Farbpartikel enthält.

8. Handsender nach einem der Ansprüche 2 bis 8, **dadurch gekennzeichnet, dass** die Halterung (17) aus Aluminium besteht.

9. Handsender nach einem der Ansprüche 1 bis 8, **dadurch gekennzeichnet, dass** dessen Komponenten ineinander steckbar ausgeführt sind.

10. Handsender nach einem der Ansprüche 1 bis 9, **dadurch gekennzeichnet, dass** das Einlegeteil (7) in das schalenförmig ausgebildete Gehäuseoberteil (2) einlegbar ist und dabei die Tastenfelder (11) des Einlegeteils (7) durch Ausnehmungen (13) des Gehäuseoberteils (2) geführt sind.

11. Handsender nach Anspruch 10, **dadurch gekennzeichnet, dass** das Einlegeteil (7) eine die Tastenfelder (11) umschließende erste Dichtungsleiste (15) als Dichtung für die Ausnehmungen (13) aufweist.

12. Handsender nach einem der Ansprüche 10 oder 11, **dadurch gekennzeichnet, dass** am äußeren Rand des Einlegeteils (7) eine zweite Dichtungsleiste (15) als Dichtung zwischen Gehäuseoberteil (2) und Gehäuseunterteil (3) vorgesehen ist.

13. Handsender nach Anspruch 12, **dadurch gekennzeichnet, dass** das Einlegeteil (7) schalenförmig ausgebildet ist und dessen Außenkontur an die Kontur der Innenwand des Gehäuseoberteils (2) angepasst ist.

14. Handsender nach Anspruch 13, **dadurch gekennzeichnet, dass** die Platine (8) in das Einlegeteil (7) einlegbar ist.

15. Handsender nach Anspruch 14, **dadurch gekennzeichnet, dass** die Ränder der Platine (8) zumindest abschnittsweise dicht an dem Einlegeteil (7) anliegen.

16. Handsender nach einem der Ansprüche 14 oder 15, **dadurch gekennzeichnet, dass** sämtliche Elektronikkomponenten auf der Platine (8) integriert sind.

17. Handsender nach Anspruch 16, **dadurch gekennzeichnet, dass** auf der Platine (8) eine autarke Energieversorgung vorgesehen ist.

18. Handsender nach einem der Ansprüche 1 bis 17, **dadurch gekennzeichnet, dass** das Gehäuseunterteil (3) auf das Gehäuseoberteil (2) aufsetzbar und an diesem fixierbar ist.

19. Handsender nach Anspruch 18, **dadurch gekennzeichnet, dass** zur Fixierung des Gehäuseunterteils (3) am Gehäuseoberteil (2) Schraubverbindungen vorgesehen sind.

20. Handsender nach einem der Ansprüche 2 bis 19, **dadurch gekennzeichnet, dass** die Halterung (17) eine dicht am Gehäuseunterteil (3) anliegende Rückwand (17a) und zwei an diese anschließende, die seitlichen Ränder des Gehäuses umschließenden Seitenwände (17b) aufweist.

21. Handsender nach Anspruch 20, **dadurch gekennzeichnet, dass** die am Gehäuseoberteil (2) angeordneten Tastenfelder (11) zwischen den Rändern der Seitenwände (17b) der Halterung (17) freiliegen.

22. Handsender nach einem der Ansprüche 20 oder 21, **dadurch gekennzeichnet, dass** die Halterung (17) mit der Rückwand an einer Auflage befestigbar ist.

23. Handsender nach einem der Ansprüche 20 bis 22, **dadurch gekennzeichnet, dass** dessen Gehäuse von einer Befestigungs-Bohrung durchsetzt ist, in welche eine Befestigungsschraube (18) zur Fixierung an der Halterung (17) einführbar ist.

24. Handsender nach Anspruch 23, **dadurch gekennzeichnet, dass** der im Gehäuseoberteil (2) liegende Kopf der Befestigungsschraube (18) mittels einer Blindkappe (20) abdeckbar ist.

25. Handsender nach einem der Ansprüche 20 bis 24, **dadurch gekennzeichnet, dass** der untere Rand der Halterung (17) auf einem Absatz (21) des Gehäuseunterteils (3) aufsetzbar ist.

26. Handsender nach einem der Ansprüche 1 bis 25, **dadurch gekennzeichnet, dass** in dem Gehäuseoberteil (2) ein Sichtfenster integriert ist, durch welches Anzeigeelemente sichtbar sind.

27. Handsender nach einem der Ansprüche 1 bis 26, **dadurch gekennzeichnet, dass** an dessen Gehäuse ein Einstellrad ausmündet.
